# EUROPEAN PATENT SPECIFICATION

(11) **EP 1 406 311 B1**
(45) Date of publication and mention of the grant of the patent: **23.07.2008**
(21) Application number: 03255280.4
(22) Date of filing: 26.08.2003
(51) Int. Cl.: H01L 31/0203, H01L 33/00

(54) **Methods and apparatus for sensor alignment**
Ausrichtungsverfahren und Ausrichtungsvorrichtung für Sensor
Méthode et appareil d'alignement d'un capteur

(30) Priority: 02.10.2002 EP 02256848
(43) Date of publication of application: 07.04.2004
(73) Proprietor: STMicroelectronics Limited, Marlow, Buckinghamshire SL7 1YL (GB); STMicroelectronics S.A., 92120 Montrouge (FR)
(72) Inventor: Raynor, Jeff, Edinburgh EH12 5HZ (GB); Jaffard, Jean-Luc, c/o STMicroelectrics SA, 92120 Montrouge (FR)
(74) Representative: Cooper, John

(56) References cited:
- EP-A- 1 150 152
- WO-A-03/005455
- US-A- 5 854 482
- US-A- 5 949 655
- US-B1- 6 462 330

## Description

The present invention relates to methods and apparatus for sensor alignment, in particular to a method of attaching a sensor and a housing to opposite sides of a stratum, a method of attaching a sensor to a stratum, an aligned sensor package, and apparatus for aligning a sensor with respect to a housing.

In the manufacture of CMOS image sensors and bio-optical sensor systems, the packaging and assembly of the sensor is a very significant proportion of the total cost. A key requirement for sensors is accurate alignment of the sensor with respect to a housing which comprises means to transmit information to the sensor. For example, if the housing comprises a lens, it is important that the lens is accurately aligned with sensor to form an image at the correct place and orientation thereon so that the image produced is not skewed. Similarly, if the housing comprises a matter delivery system for a bio-optical sensor system, it is important that the analyte and reagent materials are delivered to the appropriate points so that the amount of light generated accurately reflects the parameter to be detected.

However, accurate alignment has to be achieved without compromising the cost of production or the size of the finished article.

Currently, the lowest cost packaging method that is practical is optical Thin Quad Flat Packaging (TQFP). However, alignment tolerances using this method are typically several hundred micrometers. It is therefore desirable to find a method of attachment of an optical sensor to a printed circuit board that results in a more accurate alignment between sensor and housing, while remaining cheap to perform in the sensor manufacture process, and that does not compromise the size of the final aligned sensor package.

Document US 5,854,482 discloses a device with a housing for a sensor. Document US 5, 949,655 discloses a mounting for a flip chip optical device. Document EP-A-1 150 152 discloses a mounting for an optical assembly.

According to a first aspect of the present invention, there is provided a method of attaching a sensor and a housing to opposite sides of a stratum as set out in Claim 1 of the attached claims.

According to a third aspect of the present invention, there is provided an aligned sensor package as set out in Claim 18 of the attached claims.

According to a fourth aspect of the present invention, there is provided apparatus for aligning a sensor with respect to a housing as set out in Claim 33 of the attached claims. Further advantageous embodiments are recited in the dependent claims.

Embodiments of the present invention will now be described, by way of example only, with reference to the accompanying drawings, in which:
Fig. 1 shows a first embodiment of the present invention, in which a lens is aligned with a sensor; and
Fig. 2 shows a second embodiment of the present invention, in which a matter delivery system is aligned with a sensor.

Several methods have been developed for attaching chips to printed circuit boards. In one such method, known as flip chip technology, a chip is bump bonded face down onto a substrate. This saves space in that the bump bonds form the electrical connections across which signals can flow between the circuitry on the chip and the printed circuit board.

However, when manufacturing optical devices, where the chip comprises a charge-coupled device or CMOS sensor with a photodiode array, flip chip technology is not used. The sensing face of the sensor needs to be exposable to light, so it is not possible to have it face down on a board.

The present invention provides methods and apparatus for the implementation of flip chip technology in the manufacture of optical sensors.

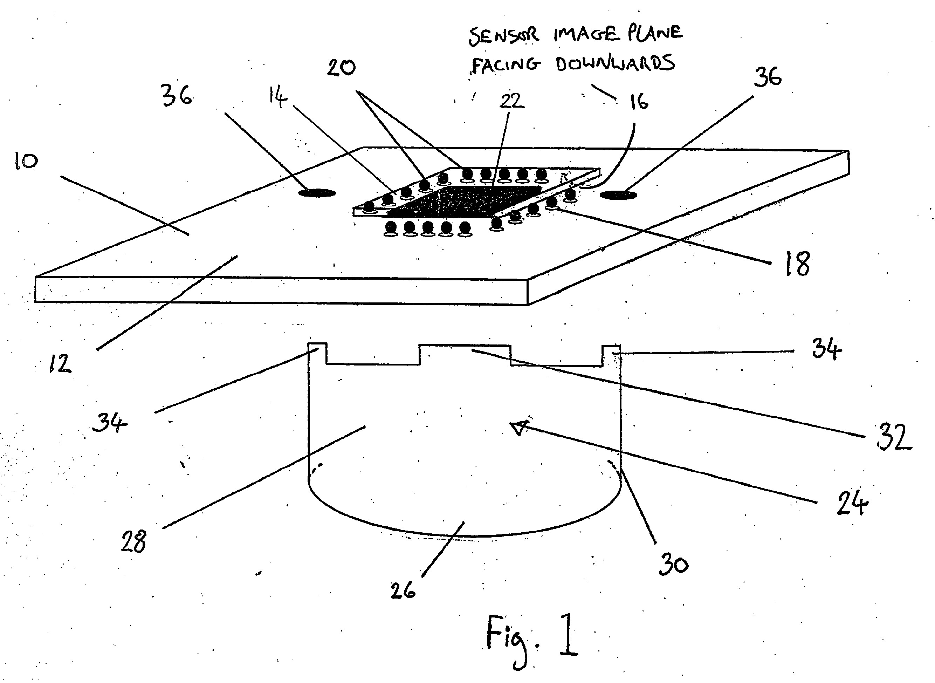

Fig. 1 illustrates a first embodiment of the present invention. A printed circuit board (PCB) 10 acts as a stratum for the attachment of a sensor 14 and a housing 24. It has a circuitry face 12, and is provided with an aperture 22. The PCB lands 18 are situated around the aperture 22 and are provided with bump bonds 20. The bump bonds 20 can be formed from an appropriate solder.

A CMOS image sensor 14 has a sensing face 16 that comprises a photodiode array together with circuitry that converts the light received by the photodiode array into electrical signals. These signals can then be transmitted through signal output contacts (not shown).

A housing 24 comprises a mating projection 32 that mates with the aperture 22 so that the housing 24 can be aligned with the PCB 10, and a lens 26.

In the preferred embodiment, the lens 26 and body 28 are integrated such that the housing 24 is a unitary article. This is a cost effective production option. However, it is equally possible that the lens 26 may be separable from the body 28.

In either case, the lens 26 and the body 28 can optionally be threadably engaged so that the position of the lens 26 is longitudinally adjustable with respect to the body 28 to enable adjustment of focus of the optical device.

Accordingly, the present invention provides for a method for attaching the sensor 14 and the housing 24 to opposite sides of the PCB 10.

Firstly, the image sensor 14 is attached to the circuitry face 12 of the PCB 10. The sensor 14 is flipped so that the sensing face 16 faces the circuitry face 12 of the PCB 10, and then positioned such that the signal output contacts of the image sensor 14 contact the bump bonds 20, which are positionally commensurate with the PCB lands 18. Thus, the image sensor is placed over the aperture 22.

The bump bonds 20 are then heated to melt the solder and to make electrical connection between the signal output contacts (not shown) of the image sensor 14 and the PCB lands 18. As the bump bonds 20 melt, they try to minimise forces in the surface tension, so deforming evenly. The net effect of this action draws the image sensor 14 into precise alignment with the aperture.

Secondly, the housing 24 is attached to the reverse side of the PCB 10. The mating projection 32 is fitted into the aperture 22 so that the housing is precisely aligned with the PCB 10. The accuracy of this alignment can be further augmented by the provision of additional apertures 36 on the PCB 10, which are engaged by corresponding auxiliary mating projections 34 on the housing 24.

Thus, when in use, the optical assembly allows light to pass through the lens 26 and onto the sensing face 16 of the image sensor 14 to be processed into electrical signals to be sent to the PCB 10. The PCB 10 can be any PCB used for any form of device that requires an optical sensor, for example a mouse for use with a computer, or for image capture by a mobile telephone.

The sensor can also be conformally coated to prevent moisture ingress.

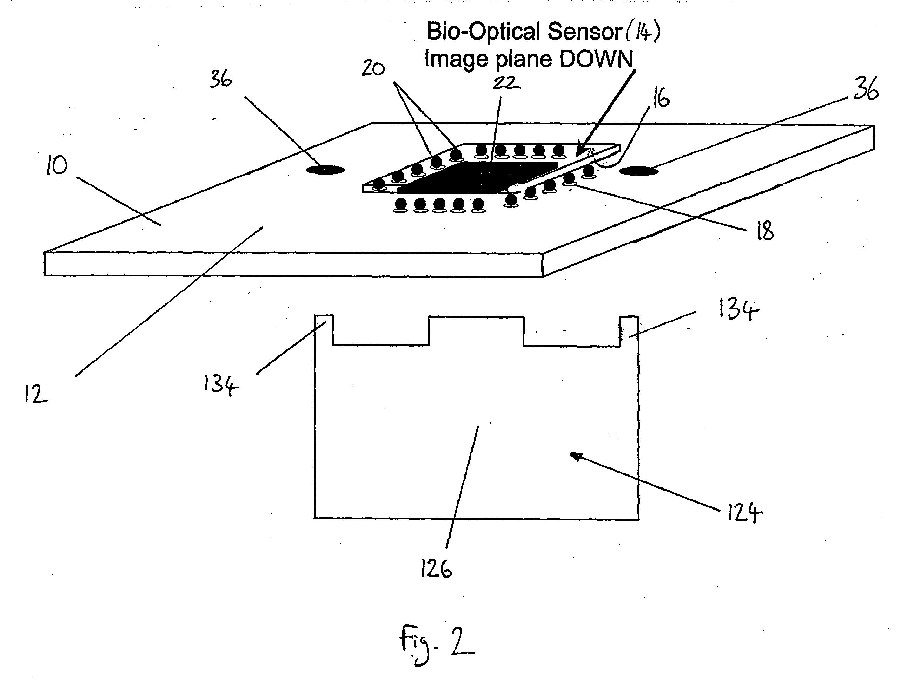

Fig. 2 illustrates a second embodiment of the present invention, which illustrates the application of the principles of the invention to alignment of a bio-optical sensor system. Like reference numerals in Fig. 2 refer to similar components as illustrated in Fig. 1.

In bio-optical sensor systems, a chemical reaction is induced between an analyte and a reagent to produce light. The amount of light produced can be measured and used to monitor the type or amount of particular materials or compounds in the analyte.

A housing 124 comprises a matter delivery system 126 for delivery of analyte and/or reagent. The delivery system could be, for example, a pump, valve or nozzle. The delivery system could be purely for the delivery of an analyte onto the sensor 14, or it could comprise a dual system for the delivery of both analyte and reagent.

The housing 124 comprises a mating projection 132 for connection to the aperture 22 of the PCB 10, and also optionally comprises auxiliary mating projections 134 for connection to mounting holes 36 in the PCB 10.

By ensuring an accurate alignment between the housing and the sensor, less analyte needs to be supplied, thus increasing both the accuracy and efficiency of the system.

The method and apparatus of the present invention provide many advantages over current methods of assembly of optical sensors. In currently used techniques, such as wire bonding or TQFP, a chip has to be attached to a lead frame and the lead frame has to be aligned with a PCB, with wire connectors interconnecting the lead frame and the PCB. These several connections lead to an accumulation of error in alignment, giving tolerances of up to several hundred micrometers, which is undesirable for optical applications, where correct alignment is important to ensure produced images are not skewed.

In contrast, the present invention provides for a direct attachment of chip to PCB, minimising cumulative errors in alignment of chip to PCB. With this accurate alignment, the projection provided on the housing can simply be placed into the aperture of the PCB so that accurate alignment of the lens to the image sensor is achieved. The accuracy of the alignment of the housing is further guaranteed with the provision of additional projections that mate with auxiliary apertures on the PCB. This results in the housing and sensor being aligned together to within about one degree of rotational accuracy, to within about twenty micrometers positional accuracy in the plane of the PCB, and to within about ten micrometers positional accuracy in the plane perpendicular to the PCB.

In addition to enabling more accurate alignment, the present invention provides a cheaper alternative to presently used methods of sensor alignment, as a result of its simple construction and lack of requirement for moulded packaging.

Also, in the manufacture of optical packaging assemblies to accurately align lenses, the sensing face of the image sensor needs to be in the focal plane of an image that is focussed through the lens. Thus, the focal length of the lens is a significant factor that increases the size of the final package. In the present invention, because the lens is positioned on the opposite side of the PCB from the sensor rather than being positioned on top of the sensor, the width of the PCB contributes towards the focal length, meaning that the size of the overall package can be reduced by a length at least equal to the width of the PCB. This relatively minor space saving may nonetheless make a significant commercial difference.

The size of the package is further minimised by the nature of the flip chip technology. As no wire bonds extrude from the perimeter of the chip, the package is compact by nature.

Various modifications and improvements may be incorporated into the above without departing from the scope of the invention which is only limited by the appended claims. In particular, the bump bonds may be made from any suitable type of solder or other electrically conductive material with suitable thermal properties; the printed circuit board could be any type of surface that can receive electrical signals; and the sensor used could be any sensor, not necessarily a charge-coupled device or a CMOS imaging sensor.

Also, the sensitive area of the sensing face of a sensor may comprise any suitable image sensor. There are many types of semiconductor based image sensors, all of which can be used within the scope of the invention, for example, charge-coupled devices, or photodiode, phototransistor or photogate sensors.

## Claims

1. A method of attaching a sensor (14) and a housing (24) to opposite sides of a stratum (10),
the sensor (14) comprising a sensing face (16) with a sensitive area, and at least one signal output contact;
the stratum (10) comprising a circuitry face (12), at least one signal input contact, and an aperture (22);
wherein the sensing face (16) of the sensor (14) is placed over the aperture (22) so that the at least one signal output contact of the sensor (14) makes contact with the at least one signal input contact of the stratum (10); and wherein the at least one signal output contact is located on the sensing face (16) of the sensor (14),
and the stratum (10) is adapted to receive the housing (24); **characterised in that** the housing (24) being provided with a formation (32) that mates with the aperture (22) in the stratum (10) such that the housing (24) and the sensor (14) are in alignment.

2. The method of any preceding claim, wherein the dimensions of the aperture (22) are of at least equal magnitude to the dimensions of the sensitive area of the sensing face of the sensor (14).

3. The method of any preceding claim, wherein the dimensions of the aperture (22) are of equal magnitude to the dimensions of the sensing face (16) of the sensor (14).

4. The method of any preceding claim, wherein bump bonds (20) are provided on the circuitry face (12) of the stratum (10), and are interposed between the signal output contacts and the signal input contacts so that signals detected by the sensor (14) can be transmitted to the circuitry of the stratum (10).

5. The method of claim 4, wherein the bump bonds (20) are positioned around the perimeter of the aperture (22).

6. The method of claim 4 or claim 5, wherein the sensor (14) is pressed to the stratum (10), and then the bump bonds (20) are heated so that they melt to draw the sensor (14) into alignment over the aperture (22).

7. The method of any preceding claim, wherein the sensor (14) is a charge-coupled device or CMOS image sensor.

8. The method of any preceding claim, wherein the sensitive area of the sensing face (16) of the sensor (14) comprises a semiconductor based image sensor.

9. The method of claim 8, wherein the semiconductor based image sensor comprises a photodiode array.

10. The method of any of claims 1 to 6, wherein the sensor is a light sensitive sensor suitable for use with a bio-optical system.

11. The method of any preceding claim, wherein the stratum (10) comprises a printed circuit board.

12. The method of any preceding claim, wherein the housing (24) is provided with projections (34) that mate with additional apertures (36) in the stratum (10).

13. The method of any preceding claim , wherein the housing (24) comprises a lens.

14. The method of any preceding claim, wherein the housing (24) comprises a lens (26) that is separable from the body (28) of the housing (24).

15. The method of any claims 13 or claim 14, wherein the lens is threadably attached to the body (28) of the housing (24).

16. The method of any of claims 1 to 12 wherein the housing comprises a matter delivery system suitable for delivering a bio-optical analyte to the sensor.

17. The method of claim 16, where the matter delivery system is also suitable for delivering a bio-optical reagent to the sensor.

18. An aligned sensor package comprising a sensor (14) and a housing (24) attached to opposite sides of a stratum (10),
the sensor (14) comprising a sensing face (16) with a sensitive area, and at least one signal output contact;
the stratum (10) comprising a circuitry face (12), at least one signal input contact, and an aperture (22);
wherein the sensing face (16) of the sensor (14) is situated over the aperture (22) so that the at least one signal output contact of the sensor (14) is in contact with the at least one signal input contact of the stratum (10), and wherein the at least one signal output contact is located on the sensing face (16) of the sensor (14),
the stratum (10) is adapted to receive the housing (24),
the housing (24) being provided with a formation (32) that mates with the aperture (22) in the stratum (10) such that the housing (24) and the sensor (14) are in alignment.

19. An aligned sensor package as claimed in claim 18, wherein the dimensions of the aperture (22) are of at least equal magnitude to the dimensions of the sensitive area of the sensing face (16) of the sensor (14).

20. An aligned sensor package as claimed in claim 18 or claim 19, wherein the dimensions of the aperture (22) are of equal magnitude to the dimensions of the sensing face (16) of the sensor (14).

21. An aligned sensor package as claimed in any of claims 18 to 20, wherein the signal output contacts and the signal input contacts are electrically connected via bump bonds (20).

22. An aligned sensor package as claimed in claim 21, wherein the bump bonds (20) are positioned around the perimeter of the aperture (22).

23. An aligned sensor package as claimed in any of claims 18 to 22, wherein the sensor (14) is a charge-coupled device or CMOS image sensor.

24. An aligned sensor package as claimed in any of claims 18 to 23, wherein the sensitive area of the sensing face (16) of the sensor (14) comprises a semiconductor based image sensor.

25. An aligned sensor package as claimed in claim 24, wherein the semiconductor based image sensor comprises a photodiode array.

26. An aligned sensor package as claimed in any of claims 18 to 22, wherein the sensor is a light sensitive sensor suitable for use with a bio-optical system.

27. An aligned sensor package as claimed in any of claims 18 to 26, wherein the stratum (10) comprises a printed circuit board.

28. An aligned sensor package as claimed in any of claims 26 to 27, wherein the housing (24) comprises a lens.

29. An aligned sensor package as claimed in any of claims 18 to 28, wherein the housing (24) comprises a lens (26) that is separable from the body (28) of the housing (24).

30. An aligned sensor package as claimed in claim 28 or 29, wherein the lens is threadably attached to the body (28) of the housing (24).

31. An aligned sensor package as claimed in any of claims 18 to 27, wherein the housing comprises a matter delivery system suitable for delivering a bio-optical analyte to the sensor.

32. An aligned sensor package as claimed in claim 31, wherein the matter delivery system is also suitable for delivering a bio-optical reagent to the sensor.

33. Apparatus for aligning a sensor (14) with respect to a housing (24), comprising;
a stratum (10) comprising a circuitry face (12) and an aperture (22), and bump bonds (20) situated on the circuitry face (12) around the perimeter of the aperture (22),
such that a sensing face (16) of the sensor (14) is attachable to the bump bonds (20), at least one signal output contact is located on the sensing face (16) of the sensor (14), and the housing (24) is attachable to the aperture (22) by means of a formation (32) that mates with the aperture (22) in the stratum (10).

34. Apparatus as claimed in claim 33, wherein the stratum (10) comprises additional apertures (36) which are mateable with projections (34) provided on the housing (24).

## Patentansprüche

1. Ein Verfahren zum Anbringen eines Sensors (14) und eines Gehäuses (24) an gegenüberliegenden Seiten einer Schicht (10),
wobei der Sensor (14) eine Abtastfläche (16) mit einem empfindlichen Bereich und mindestens einen Signalausgangskontakt beinhaltet;
wobei die Schicht (10) eine Schaltungsfläche (12), mindestens einen Signaleingangskontakt und eine Öffnung (22) beinhaltet;
wobei die Abtastfläche (16) des Sensors (14) über der Öffnung (22) platziert ist, so dass der mindestens eine Signalausgangskontakt des Sensors (14) mit dem mindestens einen Signaleingangskontakt der Schicht (10) in Kontakt tritt; und
wobei der mindestens eine Signalausgangskontakt auf der Abtastfläche (16) des Sensors (14) lokalisiert ist,
und die Schicht (10) angepasst ist, um das Gehäuse (24) zu empfangen; **dadurch gekennzeichnet, dass** das Gehäuse (24) mit einer Formation (32) versehen ist, die mit der Öffnung (22) in der Schicht (10) zusammenpasst, so dass das Gehäuse (24) und der Sensor (14) abgestimmt sind.

2. Verfahren gemäß einem der vorhergehenden Ansprüche, wobei die Ausmaße der Öffnung (22) von mindestens gleicher Größe wie die Ausmaße des empfindlichen Bereichs der Abtastfläche des Sensors (14) sind.

3. Verfahren gemäß einem der vorhergehenden Ansprüche, wobei die Ausmaße der Öffnung (22) von gleicher Größe sind wie die Ausmaße der Abtastfläche (16) des Sensors (14).

4. Verfahren gemäß einem der vorhergehenden Ansprüche, wobei auf der Schaltungsfläche (12) der Schicht (10) Bondhügelverbindungen (20) bereitgestellt sind und zwischen die Signalausgangskontakte und die Signaleingangskontakte eingefügt werden, so dass von dem Sensor (14) erkannte Signale an die Schaltung der Schicht (10) übertragen werden können.

5. Verfahren gemäß Anspruch 4, wobei die Bondhügelverbindungen (20) um den Umfang der Öffnung (22) positioniert sind.

6. Verfahren gemäß Anspruch 4 oder Anspruch 5, wobei der Sensor (14) an die Schicht (10) gepresst wird und dann die Bondhügelverbinungen (20) erwärmt werden, so dass sie schmelzen, um den Sensor (14) durch Ziehen über der Öffnung (22) abzustimmen.

7. Verfahren gemäß einem der vorhergehenden Ansprüche, wobei der Sensor (14) ein ladungsgekoppeltes Bauelement oder ein CMOS-Bildsensor ist.

8. Verfahren gemäß einem der vorhergehenden Ansprüche,
wobei der empfindliche Bereich der Abtastfläche (16) des Sensors (14) einen halbleiterbasierten Bildsensor beinhaltet.

9. Verfahren gemäß Anspruch 8, wobei der halbleiterbasierte Bildsensor eine Photodiodenanordnung beinhaltet.

10. Verfahren gemäß einem der Ansprüche 1 bis 6, wobei der Sensor ein lichtempfindlicher Sensor ist, der zur Verwendung bei einem bio-optischen System geeignet ist.

11. Verfahren gemäß einem der vorhergehenden Ansprüche, wobei die Schicht (10) eine Leiterplatte beinhaltet.

12. Verfahren gemäß einem der vorhergehenden Ansprüche, wobei das Gehäuse (24) mit Vorsprüngen (34) versehen ist, die mit zusätzlichen Öffnungen (36) in der Schicht (10) zusammenpassen.

13. Verfahren gemäß einem der vorhergehenden Ansprüche, wobei das Gehäuse (24) eine Linse beinhaltet.

14. Verfahren gemäß einem der vorhergehenden Ansprüche, wobei das Gehäuse (24) eine Linse (26) beinhaltet, die von dem Körper (28) des Gehäuses (24) trennbar ist.

15. Verfahren gemäß einem der Ansprüche 13 oder 14, wobei die Linse gewindeartig an dem Körper (28) des Gehäuses (24) angebracht ist.

16. Verfahren gemäß einem der Ansprüche 1 bis 12, wobei das Gehäuse ein Materiallieferungssystem beinhaltet, das zum Liefern eines bio-optischen Analyten an den Sensor geeignet ist.

17. Verfahren gemäß Anspruch 16, wobei das Materiallieferungssystem ebenfalls zum Liefern eines bio-optischen Reagens an den Sensor geeignet ist.

18. Ein abgestimmtes Sensorpaket, das einen Sensor (14) und ein Gehäuse (24) beinhaltet, die an gegenüberliegenden Seiten einer Schicht (10) angebracht sind,
wobei der Sensor (14) eine Abtastfläche (16) mit einem empfindlichen Bereich und mindestens einen Signalausgangskontakt beinhaltet;
wobei die Schicht (10) eine Schaltungsfläche (12), mindestens einen Signaleingangskontakt und eine Öffnung (22) beinhaltet;
wobei sich die Abtastfläche (16) des Sensors (14) über der Öffnung (22) befindet, so dass der mindestens eine Signalausgangskontakt des Sensors (14) mit dem mindestens einen Signaleingangskontakt der Schicht (10) in Kontakt steht, und wobei
der mindestens eine Signalausgangskontakt auf der Abtastfläche (16) des Sensors (14) lokalisiert ist,
die Schicht (10) angepasst ist, um das Gehäuse (24) zu empfangen,
das Gehäuse (24) mit einer Formation (32) versehen ist, die mit der Öffnung (22) in der Schicht (10) zusammenpasst, so dass das Gehäuse (24) und der Sensor (14) abgestimmt sind.

19. Abgestimmtes Sensorpaket gemäß Anspruch 18, wobei die Ausmaße der Öffnung (22) von mindestens gleicher Größe wie die Ausmaße des empfindlichen Bereichs der Abtastfläche (16) des Sensors (14) sind.

20. Abgestimmtes Sensorpaket gemäß Anspruch 18 oder Anspruch 19, wobei die Ausmaße der Öffnung (22) von gleicher Größe wie die Ausmaße der Abtastfläche (16) des Sensors (14) sind.

21. Abgestimmtes Sensorpaket gemäß einem der Ansprüche 18 bis 20, wobei die Signalausgangskontakte und die Signaleingangskontakte über Bondhügelverbindungen (20) elektrisch verbunden sind.

22. Abgestimmtes Sensorpaket gemäß Anspruch 21, wobei die Bondhügelverbindungen (20) um den Umfang der Öffnung (22) positioniert sind.

23. Abgestimmtes Sensorpaket gemäß einem der Ansprüche 18 bis 22, wobei der Sensor (14) ein ladungsgekoppeltes Bauelement oder ein CMOS-Bildsensor ist.

24. Abgestimmtes Sensorpaket gemäß einem der Ansprüche 18 bis 23, wobei der empfindliche Bereich der Abtastfläche (16) des Sensors (14) einen halbleiterbasierten Bildsensor beinhaltet.

25. Abgestimmtes Sensorpaket gemäß Anspruch 24, wobei der halbleiterbasierte Bildsensor eine Photodiodenanordnung beinhaltet.

26. Abgestimmtes Sensorpaket gemäß einem der Ansprüche 18 bis 22, wobei der Sensor ein lichtempfindlicher Sensor ist, der zur Verwendung bei einem bio-optischen System geeignet ist.

27. Abgestimmtes Sensorpaket gemäß einem der Ansprüche 18 bis 26, wobei die Schicht (10) eine Leiterplatte beinhaltet.

28. Abgestimmtes Sensorpaket gemäß einem der Ansprüche 26 bis 27, wobei das Gehäuse (24) eine Linse beinhaltet.

29. Abgestimmtes Sensorpaket gemäß einem der Ansprüche 18 bis 28, wobei das Gehäuse (24) eine Linse (26) beinhaltet, die von dem Körper (28) des Gehäuses (24) trennbar ist.

30. Abgestimmtes Sensorpaket gemäß Anspruch 28 oder 29, wobei die Linse gewindeartig an dem Körper (28) des Gehäuses (24) angebracht ist.

31. Abgestimmtes Sensorpaket gemäß einem der Ansprüche 18 bis 27, wobei das Gehäuse ein Materiallieferungssystem beinhaltet, das zum Liefern eines bio-optischen Analyten an den Sensor geeignet ist.

32. Abgestimmtes Sensorpaket gemäß Anspruch 31, wobei das Materiallieferungssystem ebenfalls zum Liefern eines bio-optischen Reagens an den Sensor geeignet ist.

33. Ein Gerät zum Abstimmen eines Sensors (14) in Bezug auf ein Gehäuse (24), das Folgendes beinhaltet;
eine Schicht (10), die eine Schaltungsfläche (12) und eine Öffnung (22) und Bondhügelverbindungen (20), die sich auf der Schaltungsfläche (12) um den Umfang der Öffnung (22) befinden, beinhaltet,
so dass eine Abtastfläche (16) des Sensors (14) an die Bondhügelverbindungen (20) anbringbar ist, mindestens ein Signalausgangskontakt auf der Abtastfläche (16) des Sensors (14) lokalisiert ist, und das Gehäuse (24) mittels einer Formation (32), die mit der Öffnung (22) in der Schicht (10) zusammenpasst, an der Öffnung (22) anbringbar ist.

34. Gerät gemäß Anspruch 33, wobei die Schicht (10) zusätzliche Öffnungen (36) beinhaltet, die mit auf dem Gehäuse (24) bereitgestellten Vorsprüngen (34) zusammenpassen.

## Revendications

1. Une méthode pour attacher un capteur (14) et un logement (24) sur des côtés opposés d'une couche (10),
le capteur (14) comprenant une face de détection (16) ayant une zone sensible, et au moins un contact de sortie de signai ;
la couche (10) comprenant une face de circuiterie (12), au moins un contact d'entrée de signal, et une ouverture (22) ;
dans laquelle la face de détection (16) du capteur (14) est placée par-dessus l'ouverture (22) de sorte que le au moins un contact de sortie de signal du capteur (14) entre en contact avec le au moins un contact d'entrée de signal de la couche (10) ; et
dans laquelle le au moins un contact de sortie de signal est situé sur la face de détection (16) du capteur (14),
et la couche (10) est adaptée pour recevoir le logement (24) ; **caractérisée en ce que**
le logement (24) est muni d'une formation (32) qui s'accouple avec l'ouverture (22) dans la couche (10) de façon à ce que le logement (24) et le capteur (14) soient en alignement.

2. La méthode de n'importe quelle revendication précédente, dans laquelle les dimensions de l'ouverture (22) sont de grandeur au moins égale aux dimensions de la zone sensible de la face de détection du capteur (14).

3. La méthode de n'importe quelle revendication précédente, dans laquelle les dimensions de l'ouverture (22) sont de grandeur égale aux dimensions de la face de détection (16) du capteur (14).

4. La méthode de n'importe quelle revendication précédente, dans laquelle des liaisons en plots (20) sont prévues sur la face de circuiterie (12) de la couche (10), et sont interposées entre les contacts de sortie de signal et les contacts d'entrée de signal de sorte que des signaux détectés par le capteur (14) puissent être transmis à la circuiterie de la couche (10).

5. La méthode de la revendication 4, dans laquelle les liaisons en plots (20) sont positionnées autour du périmètre de l'ouverture (22).

6. La méthode de la revendication 4 ou de la revendication 5, dans laquelle le capteur (14) est appuyé sur la couche (10), et les liaisons en plots (20) sont ensuite chauffées de sorte qu'elles fondent afin de tirer le capteur (14) pour le mettre en alignement par-dessus l'ouverture (22).

7. La méthode de n'importe quelle revendication précédente, dans laquelle le capteur (14) est un dispositif à couplage de charge ou capteur d'image CMOS.

8. La méthode de n'importe quelle revendication précédente, dans laquelle la zone sensible de la face de détection (16) du capteur (14) comprend un capteur d'image à base de semi-conducteur.

9. La méthode de la revendication 8, dans laquelle le capteur d'image à base de semi-conducteur comprend une matrice de photodiodes.

10. La méthode de n'importe lesquelles des revendications 1 à 6, dans laquelle le capteur est un capteur photosensible qui convient pour être utilisé avec un système bio-optique.

11. La méthode de n'importe quelle revendication précédente, dans laquelle la couche (10) comprend une carte de circuit imprimé.

12. La méthode de n'importe quelle revendication précédente, dans laquelle le logement (24) est muni de projections (34) qui s'accouplent avec des ouvertures supplémentaires (36) dans la couche (10).

13. La méthode de n'importe quelle revendication précédente, dans laquelle le logement (24) comprend une lentille.

14. La méthode de n'importe quelle revendication précédente, dans laquelle le logement (24) comprend une lentille (26) qui peut être séparée du corps (28) du logement (24).

15. La méthode de n'importe lesquelles des revendications 13 et 14, dans laquelle la lentille est attachée par filetage au corps (28) du logement (24).

16. La méthode de n'importe lesquelles des revendications 1 à 12 dans laquelle le logement comprend un système d'apport de matière convenant pour apporter un analyte bio-optique au capteur.

17. La méthode de la revendication 16, où le système d'apport de matière convient aussi pour apporter un réactif bio-optique au capteur.

18. Un ensemble à capteur aligné comprenant un capteur (14) et un logement (24) attachés sur des côtés opposés d'une couche (10),
le capteur (14) comprenant une face de détection (16) ayant une zone sensible, et au moins un contact de sortie de signai ;
la couche (10) comprenant une face de circuiterie (12), au moins un contact d'entrée de signal, et une ouverture (22) ;
dans lequel la face de détection (16) du capteur (14) est située par-dessus l'ouverture (22) de sorte que le au moins un contact de sortie de signal du capteur (14) soit en contact avec le au moins un contact d'entrée de signal de la couche (10), et dans lequel
le au moins un contact de sortie de signal est situé sur la face de détection (16) du capteur (14),
la couche (10) est adaptée pour recevoir le logement (24),
le logement (24) étant muni d'une formation (32) qui s'accouple avec l'ouverture (22) dans la couche (10) de façon à ce que le logement (24) et le capteur (14) soient en alignement.

19. Un ensemble à capteur aligné tel que revendiqué dans la revendication 18, dans lequel les dimensions de l'ouverture (22) sont de grandeur au moins égale aux dimensions de la zone sensible de la face de détection (16) du capteur (14).

20. Un ensemble à capteur aligné tel que revendiqué dans la revendication 18 ou la revendication 19, dans lequel les dimensions de l'ouverture (22) sont de grandeur égale aux dimensions de la face de détection (16) du capteur (14).

21. Un ensemble à capteur aligné tel que revendiqué dans n'importe lesquelles des revendications 18 à 20, dans lequel les contacts de sortie de signal et les contacts d'entrée de signal sont électriquement connectés par le biais de liaisons en plots (20).

22. Un ensemble à capteur aligné tel que revendiqué dans la revendication 21, dans lequel les liaisons en plots (20) sont positionnées autour du périmètre de l'ouverture (22).

23. Un ensemble à capteur aligné tel que revendiqué dans n'importe lesquelles des revendications 18 à 22, dans lequel le capteur (14) est un dispositif à couplage de charge ou capteur d'image CMOS.

24. Un ensemble à capteur aligné tel que revendiqué dans n'importe lesquelles des revendications 18 à 23, dans lequel la zone sensible de la face de détection (16) du capteur (14) comprend un capteur d'image à base de semi-conducteur.

25. Un ensemble à capteur aligné tel que revendiqué dans la revendication 24, dans lequel le capteur d'image à base de semi-conducteur comprend une matrice de photodiodes.

26. Un ensemble à capteur aligné tel que revendiqué dans n'importe lesquelles des revendications 18 à 22, dans lequel le capteur est un capteur photosensible qui convient pour être utilisé avec un système bio-optique.

27. Un ensemble à capteur aligné tel que revendiqué dans n'importe lesquelles des revendications 18 à 26, dans lequel la couche (10) comprend une carte de circuit imprimé.

28. Un ensemble à capteur aligné tel que revendiqué dans n'importe lesquelles des revendications 26 et 27, dans lequel le logement (24) comprend une lentille.

29. Un ensemble à capteur aligné tel que revendiqué dans n'importe lesquelles des revendications 18 à 28, dans lequel le logement (24) comprend une lentille (26) qui peut être séparée du corps (28) du logement (24).

30. Un ensemble à capteur aligné tel que revendiqué dans la revendication 28 ou 29, dans lequel la lentille est attachée par filetage au corps (28) du logement (24).

31. Un ensemble à capteur aligné tel que revendiqué dans n'importe lesquelles des revendications 18 à 27, dans lequel le logement comprend un système d'apport de matière convenant pour apporter un analyte bio-optique au capteur.

32. Un ensemble à capteur aligné tel que revendiqué dans la revendication 31, dans lequel le système d'apport de matière convient aussi pour apporter un réactif bio-optique au capteur.

33. Appareil pour aligner un capteur (14) par rapport à un logement (24), comprenant :
une couche (10) comprenant une face de circuiterie (12) et une ouverture (22), et des liaisons en plots (20) situées sur la face de circuiterie (12) autour du périmètre de l'ouverture (22),
de sorte qu'une face de détection (16) du capteur (14) peut être attachée aux liaisons en plots (20), au moins un contact de sortie de signal est situé sur la face de détection (16) du capteur (14), et le logement (24) peut être attaché sur l'ouverture (22) au moyen d'une formation (32) qui s'accouple avec l'ouverture (22) dans la couche (10).

34. Appareil tel que revendiqué dans la revendication 33, dans lequel la couche (10) comprend des ouvertures supplémentaires (36) qui peuvent s'accoupler avec des projections (34) prévues sur le logement (24).
